# FASCICULE DE BREVET EUROPEEN

(11) **EP 0 412 854 B1**
(45) Date de publication et mention de la délivrance du brevet: **14.09.1994**
(21) Numéro de dépôt: 90400816.6
(22) Date de dépôt: 23.03.1990
(51) Int. Cl.: H03H 9/145, H03H 9/02

(54) **Dispositif acoustoélectrique à ondes de surface perfectionné**
Verbesserte Akusto-elektrische Oberflächenwellenanordnung
Improved acoustoelectric surface wave device

(30) Priorité: 10.08.1989 FR 8910784
(43) Date de publication de la demande: 13.02.1991
(73) Titulaire: DASSAULT ELECTRONIQUE, F-92214 Saint-Cloud (FR)
(72) Inventeur: Noel, Benoît, F-78960 Voisins Le Bretonneux (FR); Foure, Jean-Louis, F-91370 Verrieres Le Buisson (FR)
(74) Mandataire: Plaçais, Jean-Yves

(56) Documents cités:
- EP-A- 0 057 555
- DE-A- 2 738 192
- US-A- 3 800 247

## Description

L'invention concerne des ensembles de transducteurs électrique/acoustique à ondes de surface.

Pour les réaliser, on part d'un mince substrat piézo-électrique plan. Par micro-lithographie ou par d'autres techniques de micro-usinage, on réalise sur une grande face de ce substrat deux rangées de doigts conducteurs fins qui sont parallèles entre eux dans chaque rangée.

Sous certaines conditions, il apparaît alors un couplage entre les deux rangées de doigts par des ondes acoustiques de surface qui se propagent dans le substrat piézo-électrique. Ce couplage possède des caractéristiques temporelles et fréquentielles qui dépendent de la géométrie des doigts, principalement de leur largeur, ainsi que de phénomènes de propagation acoustique d'une rangée de doigts à l'autre.

Jusqu'à présent, ces dispositifs ont été utilisés surtout pour des bandes passantes relativement étroites. Ils donnent alors satisfaction et on sait raisonnablement bien prévoir leur comportement.

Il en est différemment pour les applications à large bande ou très large bande auxquelles s'intéresse la Demanderesse. "Très large bande" signifie ici que la bande utile peut couvrir jusqu'à la valeur de sa fréquence centrale.

Dans ces applications à large bande (US-A-3 800 247), les deux rangées de doigts sont en général inclinées sur la perpendiculaire à la direction des doigts. De plus, la direction moyenne de ces rangées est le plus souvent curviligne. On cherche en effet à maîtriser le nombre de doigts de l'une et l'autre rangées qui vont coopérer pour fournir le couplage acoustique et ce, pour chaque valeur de fréquence donnée à l'intérieur de la bande de travail.

Dans l'une des structures connues, dites à doigts simples, la largeur d'un doigt est égale au quart de la longueur d'onde acoustique instantanée (locale) pour la fréquence associée. Il en est de même pour la distance entre doigts adjacents. La limite des techniques classiques de micro-lithographie font que ces structures opèrent actuellement jusqu'à 2 GHz environ, (fréquence fondamentale). Elles peuvent avoir une bonne réponse en fréquence et en phase, mais souffrent par contre d'une réponse temporelle parasite dite triple écho, et située à environ 20 à 25 dB sous le signal utile.

Il a été envisagé d'utiliser des structures dites "à doigts dédoublés", où la largeur des doigts est le huitième de la longueur d'onde acoustique instantanée. Le parasite temporel de triple écho peut alors être abaissé jusqu'à 40 à 45 dB sous le signal utile. Mais ces structures sont difficiles à réaliser. A précision égale en micro-lithographie submicronique, elles ne permettent d'atteindre que des fréquences deux fois moins élevées que les structures à doigts simples.

De plus, l'utilisation de doigts dédoublés stimule à son tour une réponse fréquentielle parasite en harmonique 3 qui peut se trouver à -15 dB sous la réponse fondamentale, et dont la bande est trois fois plus large que celle de la réponse fondamentale.

L'homme de l'art connaît parfaitement les inconvénients qui résultent des remarques ci-dessus.

Il n'existe donc pas actuellement de solution véritablement satisfaisante lorsqu'on veut travailler en large bande, surtout si l'on veut, en outre, monter en fréquence avec un niveau d'écho triple temporel réduit.

L'invention vient apporter une solution à ce problème.

Comme précédemment indiqué, l'invention s'applique à des transducteurs électrique/acoustique/électrique à ondes de surface, du type comportant, sur une grande face d'un substrat piézo-électrique plan, une première rangée de doigts conducteurs parallèles et une seconde rangée de doigts conducteurs parallèles, ces deux rangées étant espacées l'une de l'autre, pour permettre un couplage par la propagation d'ondes acoustiques de surface entre les doigts de la première rangée et ceux de la seconde, les doigts de ces deux rangées étant inclinés sur la direction de propagation de ces ondes acoustiques de surface, les doigts des deux rangées possédant, en correspondance d'une rangée à l'autre, des géométries individuelles choisies localement en fonction d'une fréquence de travail, et échelonnées globalement sur une gamme de fréquences de travail, pour permettre un couplage acoustique à large bande de fréquences entre les deux rangées de doigts, tandis que l'implantation des doigts le long de chaque rangée obeit à une séquence prédéterminée, combinée avec la facteur d'échelle lié à la fréquence de travail.

Selon un aspect de l'invention, l'une des deux rangées présente une exception par rapport à ladite séquence, cette exception étant répétée de manière sensiblement périodique le long de cette séquence.

Bien que d'autres dispositions puissent être envisagées, la Demanderesse estime actuellement qu'une et une seule des deux distributions doit être ainsi modifiée, l'autre gardant une distribution rigoureusement régulière de ses doigts, avec en principe un espacement entre doigts et une largeur de doigts tous deux égaux au quart de la longueur d'onde acoustique environ.

On aura remarqué que la caractéristique ci-dessus intéresse essentiellement les doigts et eux seuls. On peut donc penser à des nombreuses dispositions des rangées qui soient conformes à l'invention.

Dès lors que les doigts des deux rangées sont parallèles entre eux, on peut leur donner des géométries individuelles qui varient progressivement le long de chaque rangée pour couvrir une très large bande de fréquence, tout en se correspondant d'une rangée à l'autre, perpendiculairement à la direction commune de ces doigts.

En d'autres termes, la largeur d'un doigt est pratiquement toujours un sous-multiple prédéterminé de la demi-longueur d'onde acoustique instantanée désirée, en principe le sous-multiple d'ordre 2, c'est-à-dire le quart de longueur d'onde. La distance entre doigts adjacents est sensiblement égale à ce sous-multiple, c'est-à-dire au quart de longueur d'onde. Toutefois, elle en devient un multiple, en principe d'ordre 2, pour les "endroits" où la séquence d'accrochage des doigts est modifiée.

Très avantageusement, ces "endroits" se trouvent tous les trois ou quatre doigts.

Il a déjà été relevé que les première et seconde rangées s'étendent en général suivant des axes curvilignes. On peut néanmoins leur associer des directions générales.

Dans une première famille de dispositifs, ces directions générales sont inclinées différemment sur la perpendiculaire à la direction des doigts. Le dispositif possède alors des caractéristiques de ligne dispersive.

Dans une autre famille, les directions générales des première et seconde rangées ont sensiblement la même inclinaison sur la perpendiculaire à la direction des doigts. Le dispositif possède alors des caractéristiques de ligne à retard non dispersive.

D'autres caractéristiques et avantages de l'invention apparaîtront à l'examen de la description détaillée ci-après, ainsi que des dessins annexés, sur lesquels :
- la figure 1 est un schéma illustrant une première famille de dispositifs auxquels peut s'appliquer l'invention ;
- la figure 2 est un schéma illustrant une seconde famille de dispositifs auxquels peut s'appliquer l'invention ;
- la figure 3 illustre une structure dite "doigts simples"; tandis que les figures 3A et 3B illustrent le parasite de triple écho de cette structure ;
- la figure 4 illustre la structure dite à "doigts dédoublés", tandis que la figure 4A est un diagramme temporel illustrant sa réponse perturbatrice sur harmonique 3 ;
- la figure 5 illustre un exemple de dispositifs perfectionnés selon l'invention ; et
- la figure 6 illustre un autre exemple de dispositifs perfectionnés selon l'invention.

Il est clair que la géométrie est très importante pour la présente invention. De plus, les dessins annexés sont, pour l'essentiel, de caractère certain. En conséquence, ils sont à considérer comme incorporés à la description, et pourront servir non seulement à mieux faire comprendre celle-ci mais aussi le cas échéant contribuer à la définition de l'invention.

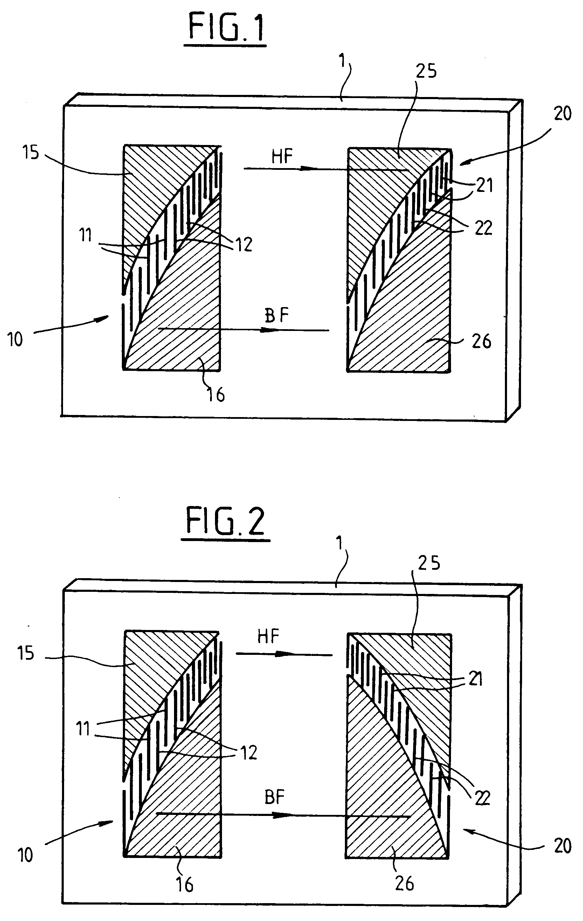

Les figures 1 et 2 font apparaître un substrat piézo-électrique 1 dont l'épaisseur peut être de l'ordre de 0,5 mm. Ses autres dimensions vont de quelques millimètres à quelques dizaines de millimètres, voire plus.

Sur une grande face de substrat, sont disposées deux rangées de doigts 10 et 20.

Ici, la rangée de doigts 10 est côtoyée par deux plages conductrices 15 et 16, électriquement séparées, par exemple en aluminium, d'épaisseur 200 nanomètres. En alternance, les doigts 11 sont connectés à la plage 15, tandis que les doigts 12 sont connectés à la plage 16. De même, la rangée 20 est munie de plages 25 et 26 avec interconnexion alternée des doigts 21 à la plage 25 et des doigts 22 à la plage 26.

Les figures 1 et 2 font encore apparaître que, en partie haute, les doigts sont plus resserrés. Ils sont également plus étroits, ce que le dessin ne montre pas ici. Il en résulte que, pour la partie haute des figures 1 et 2, le couplage entre les doigts situés sur la même horizontale interviendra dans la partie haute de la gamme de fréquence concernée. A l'opposé, au bas des figures 1 et 2, les doigts sont plus espacés et leurs largeurs individuelles plus grandes. En conséquence, le couplage intéressera ici la partie basse de la gamme de fréquence concernée.

La différence entre les figures 1 et 2 est la suivante :
- sur la figure 1, les directions générales des rangées dans lesquelles s'étendent les rangées 10 et 20 sont sensiblement parallèles (dans la mesure où on peut parler de parallélisme pour des directions curvilignes). En conséquence, le temps de propagation de l'onde de la rangée 10 à la rangée 20 sera sensiblement le même pour toutes les fréquences. Le dispositif illustré sur la figure 1 peut donc être considéré comme une ligne à retard non dispersive.
- il en est différemment sur la figure 2, où l'on observe que la distance entre les doigts va diminuer progressivement lorsqu'on passe du bas de la figure qui intéresse les basses fréquences au haut de la figure qui intéresse les hautes fréquences. Il s'agit donc d'une ligne dispersive qui possède des propriétés sélectives en fréquence.

L'invention s'applique aussi bien aux dispositifs décrits ci-dessus (connus sous le nom de "down chirp" dans la littérature anglo-saxonne) qu'à des dispositifs dits "up chirp" pour lesquels la largeur des doigts et la distance entre doigts augmente progressivement lorsque l'on passe du bas de la figure (qui intéresse alors les hautes fréquences) au haut de la figure (qui intéresse alors les basses fréquences).

En principe, les deux rangées sont dans tous les cas inclinées par rapport à la direction principale de propagation des ondes acoustiques. C'est pourquoi, ces structures sont souvent appelées SLT (pour "SLanted Transducer") ou même ont conservé leur appellation ancienne de "Slanted Acoustic Correlator" ou "SAC".

La Demanderesse s'est intéressée à l'application de ces structures pour faire des lignes dispersives et des lignes à retard à très large bande, notamment.

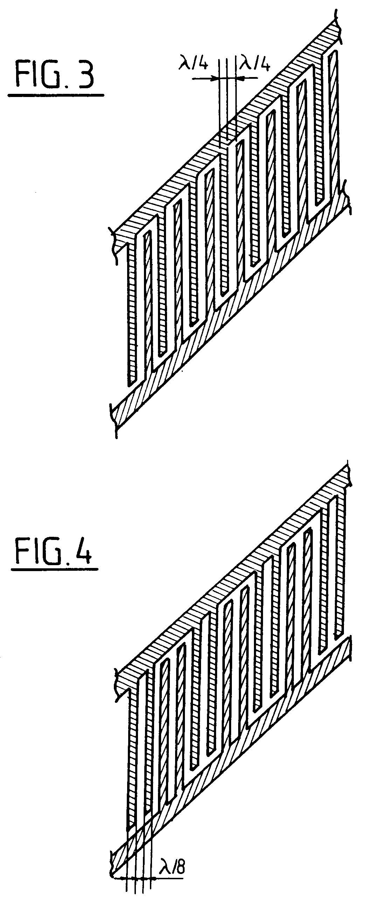

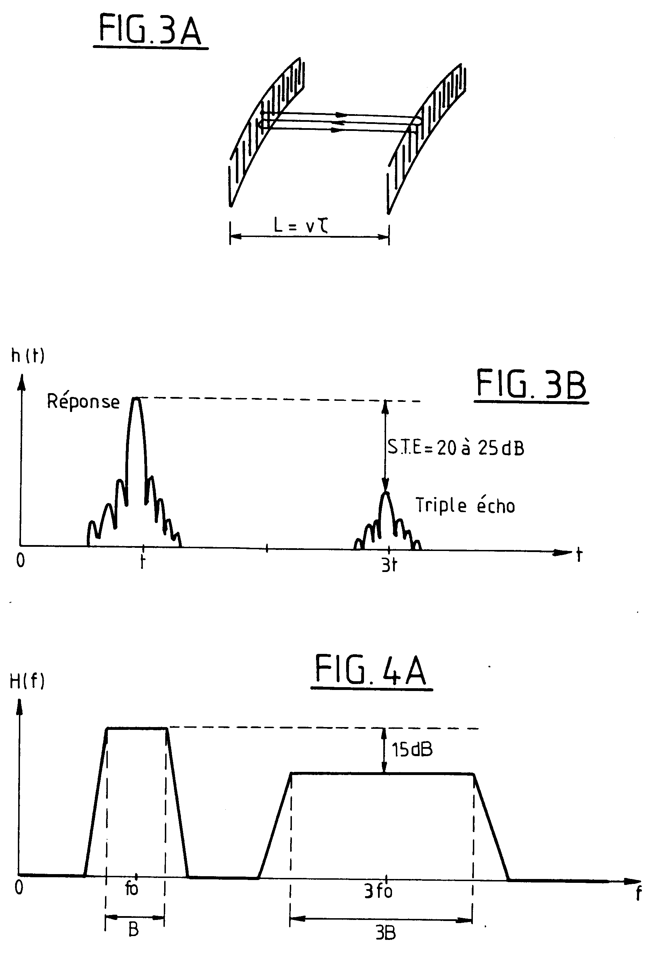

La figure 3 illustre avec plus de précision une rangée de doigts utilisables dans les structures des figures 1 et 2. Dans les applications susvisées, on a en principe utilisé jusqu'à présent des structures rigoureusement identiques pour les deux rangées de doigts.

Ici, sur la figure 3, la structure utilisée est du type dit à doigts simples. C'est-à-dire que la largeur des doigts est de l'ordre du quart de longueur d'onde acoustique instantanée, de même que l'espacement entre eux. Il s'agit là de la largeur prise dans la direction de propagation des ondes acoustiques, c'est-à-dire dans la direction perpendiculaire aux doigts. Il n'y a pas lieu de tenir compte de la direction dans laquelle s'étend la rangée elle-même.

La figure 3A montre schématiquement à quel niveau peut se situer le triple écho entre deux rangées de doigts ainsi constituées. On comprend en effet que trois trajets entre transducteurs peuvent se produire aisément sans grande perte, compte tenu de la géométrie des doigts. La figure 3B montre que la réponse de triple écho intervient donc à un temps 3t qui est le triple du temps de la réponse fondamentale, tandis que son niveau STE est situé 20 à 25 dB sous le niveau de la réponse principale.

Il est clair que, tout du moins pour certaines applications, une telle réponse peut être extrêmement gênante.

La structure à doigts simples, qui est donc la plus facile à réaliser toute chose égale par ailleurs, présente donc un inconvénient certain.

On connaît aussi les structures à doigts dédoublés, telles que celles de la figure 4.

Dans ce cas, la largeur des doigts est le huitième de longueur d'onde instantanée, de même que leur espacement.

Comme déjà indiqué, l'usage de deux structures à doigts dédoublés pour les rangées 10 et 20 fait descendre jusqu'à 40 à 45 dB la suppression de triple écho, ce qui serait satisfaisant. Malheureusement, les doigts dédoublés stimulent une réponse fréquentielle parasite en harmonique 3 (figure 4A) qui, non seulement n'est qu'à environ 15 dB de la réponse fondamentale, mais aussi et surtout possède une largeur de bande 3B, B étant celle de la réponse fondamentale.

Cet inconvénient peut être parfaitement acceptable en bande étroite, lorsque la fréquence minimale de la bande est nettement supérieure au tiers de sa fréquence maximale. Lorsqu'on veut travailler en large bande, elle est pratiquement inacceptable.

De plus, à performance fixe des techniques micro-lithographiques, les structures à doigts dédoublés n'atteignent que la moitié de la fréquence que permettent d'atteindre les structures à doigts simples.

Allant à l'encontre d'une tendance naturelle qui consiste, du moins lorsqu'on veut travailler en large bande, à utiliser des structures identiques pour les deux rangées, la Demanderesse a constaté que, sous certaines conditions, il était possible d'utiliser des géométries différentes pour les doigts des deux rangées.

Plus exactement, la géométrie individuelle des doigts n'est pas fondamentalement modifiée.

Ce qui va être modifié, dans l'une des deux rangées (et en principe seulement dans l'une des deux rangées), c'est la distribution des doigts selon la rangée, plus exactement leur séquence d'accrochage.

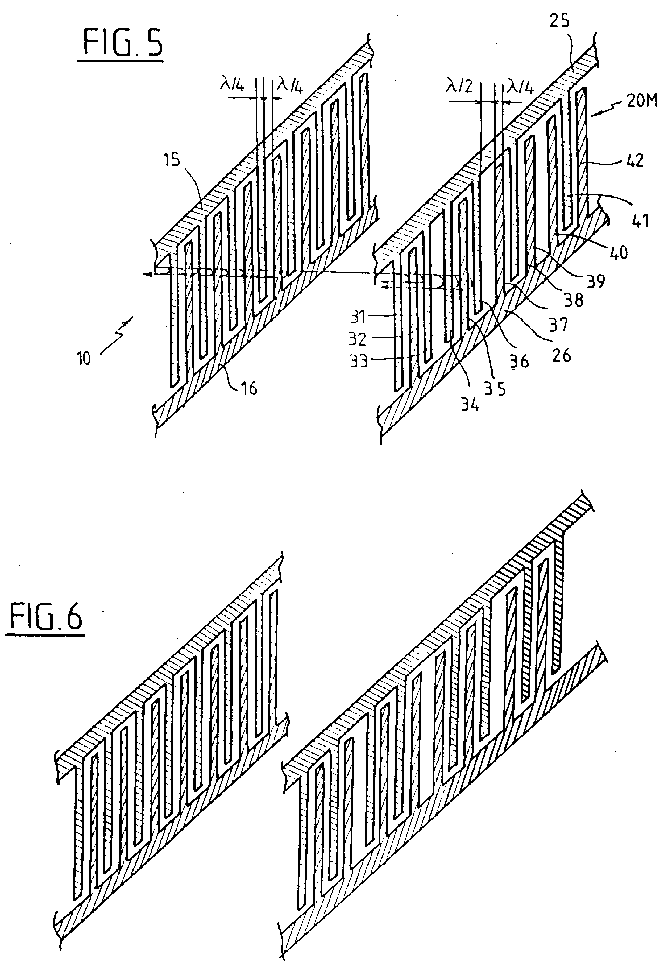

Ceci est illustré sur la figure 5 où l'on voit à gauche le transducteur en doigts simples de la figure 3.

A droite, est représentée partiellement la structure nouvelle de la présente invention.

Elle se caractérise par le fait que, périodiquement, on fait passer à la demi-longueur d'onde l'espacement entre certains doigts adjacents et que l'on modifie la séquence d'accrochage des doigts.

Ceci permet d'améliorer la réponse globale du dispositif, car on bénéficie de l'excellent filtrage fréquentiel de la structure à doigts simples, tandis que la structure nouvelle de droite, si elle possède une réponse harmonique plus complexe, présente par contre une réponse temporelle excellente.

On va donc avoir des groupes consécutifs de doigts possédant les propriétés suivantes :
- deux groupes consécutifs, tels que 31 à 33 et 34 à 36, sont rattachés à la même plage conductrice ; ici, il y a à chaque fois deux doigts attachés à la plage 25 pour 1 attaché à la plage 26.
- inversement, dans les groupes suivants, qui comportent les doigts 37 à 39 et 40 à 42, on aura la même structure, mais rattachée d'une manière symétrique, c'est-à-dire qu'un seul doigt est attaché à la plage conductrice 25 tandis que deux doigts sont attachés à la plage conductrice 26.

Ce qui vient d'être décrit en référence à la figure 5 vaut pour des triplets de doigts.

Mais, on peut également appliquer ces mêmes principes avec des groupes de quatre doigts, ou plus. Un exemple à quatre doigts est illustré sur la figure 6. A titre de comparaison, la Demanderesse a réalisé deux lignes à retard articulées sur des structures de base à doigts simples, c'est-à-dire dont la largeur est le quart de la longueur d'onde instantanée.

La distribution ou séquence d'accrochage élémentaire de la figure 3 peut être représentée par la suite périodique de nombres
1,0,-1,0,1,0,-1,0 où 1 désigne un doigt accroché en haut, 0 un espace de largeur d'un quart de longueur d'onde instantanée et -1 un doigt accroché en bas, avec une largeur de doigt d'un quart de longueur d'onde instantanée.

Celle de la figure 4 doigts dédoublés) est alors de la forme :
1,0,1,0,-1,0,-1,0,1,0,1,0,-1,0,-1,0
avec une largeur de doigt d'un huitième de longueur d'onde instantanée.

Les nouvelles structures proposées ont une largeur de doigt quart d'onde, mais avec des séquences d'accrochage modifiées, de périodicité spatiale supérieure, en particulier :
- sur la figure 5 (à droite "groupes de 3")
   1,0,-1,0,1,0,0,1,0,-1,0,1,0,0-1,0,1,0,-1,0,0,-1,0,1,0,-1,0,0, etc
- sur la figure 6 (à droite "groupes de 4")
   1,0,-1,0,1,0,-1,0,0,1,0,-1,0,1,0,-1,0,0
   -1,0,1,0,-1,0,1,0,0,-1,0,1,0,-1,0,1,0,0

Ces séquences élémentaires sont ensuite répétées jusqu'à l'obtention des caractéristiques de dispersion souhaitées pour le dispositif.

Une première ligne à retard a été réalisée avec deux structures à doigts simples strictes. Une seconde ligne à retard a été réalisée avec une structure à doigts simples et une structure nouvelle selon l'invention, comme illustré sur la figure 5 (remarque étant faite qu'on pourrait tout aussi bien mettre la structure nouvelle à gauche et la structure classique à droite).

Les niveaux de triple écho étaient à -24 dB pour la ligne à retard classique, contre -50 dB pour la ligne en retard nouvelle selon la présente invention. La ligne à retard nouvelle présente en outre une excellente réponse fréquentielle en amplitude, sans les ondulations habituelles dues au triple écho.

On a également pu observer une très faible variation du temps de groupe sur toute la bande utile, que l'on pouvait difficilement obtenir jusqu'à présent.

Bien entendu, ce qui précède et a été décrit à propos de structures de base à doigts simples peut aussi s'appliquer à des structures à doigts dédoublés.

En outre, l'invention n'est nullement limitée aux exemples particuliers d'application décrits. Elle peut en effet s'étendre à tout dispositif utilisant des rangées de doigts couplés acoustiquement par ondes de surface à des fins de traitement de signaux électromagnétiques.

## Revendications

1. Dispositif acoustoélectrique à ondes de surface, comportant, sur une grande face d'un substrat piézo-électrique plan, une première rangée (10) de doigts conducteurs parallèles et une seconde rangée (20) de doigts conducteurs parallèles, ces deux rangées étant espacées l'une de l'autre, pour permettre un couplage par la propagation d'ondes acoustiques de surface (HF,BF) entre les doigts de la première rangée (11,12) et ceux de la seconde (21,22), lesquels doigts sont inclinés sur la direction de propagation de ces ondes acoustiques de surface,
les doigts des deux rangées possédant, en correspondance d'une rangée à l'autre, des géométries individuelles choisies localement en fonction d'une fréquence de travail, et échelonnées globalement sur une large gamme de fréquences de travail, pour permettre un couplage acoustique à large bande de fréquences entre les deux rangées de doigts,
tandis que l'implantation des doigts le long de chaque rangée obéit à une séquence prédéterminée, combinée avec le facteur d'échelle lié à la fréquence de travail,
caractérisé en ce que l'une (20M) des deux rangées présente une exception par rapport à ladite séquence, cette exception étant répétée de manière sensiblement périodique le long de cette séquence.

2. Transducteur selon la revendication 1, caractérisé en ce que les doigts des deux rangées (10,20) sont parallèles entre eux, et en ce qu'ils présentent des géométries individuelles qui varient progressivement le long de chaque rangée pour couvrir une très large bande de fréquences, tout en se correspondant d'une rangée à l'autre perpendiculairement à la direction des doigts.

3. Transducteur selon la revendication 2, caractérisé en ce que la largeur d'un doigt (11,12,21,22) est sensiblement un sous-multiple prédéterminé de la demi-longueur d'onde acoustique instantanée associée, tandis que la distance entre doigts adjacents est sensiblement égale à ce sous-multiple, ou multiple de celui-ci.

4. Transducteur selon l'une des revendications précédentes, caractérisé en ce que ladite exception comprend un élargissement de l'écartement entre doigts, tous les trois ou quatre doigts.

5. Transducteur selon l'une des revendications 2 à 4, caractérisé en ce que les directions moyennes des première et seconde rangées (10,20) sont inclinées différemment sur la perpendiculaire à la direction des doigts, ce qui confère au transducteur des caractéristiques de ligne dispersive.

6. Transducteur selon l'une des revendications 2 à 4, caractérisé en ce que les directions moyennes des première et seconde rangées (10,20) ont sensiblement la même inclinaison sur la perpendiculaire à la direction des doigts, ce qui confère au transducteur des caractéristiques de ligne à retard non dispersive.

7. Transducteur selon l'une des revendications 1 à 6, dans lequel, pour l'une au moins (20M) des rangées (10,20), les doigts sont respectivement reliés à au moins deux plages conductrices (15,16;25,26) qui s'étendent de part et d'autre de la rangée, caractérisé en ce que c'est ladite rangée (20M) munie de plages qui comporte ladite exception, laquelle comprend le fait que, sensiblement périodiquement le long de la séquence, deux doigts consécutifs (33,34;39,40) sont rattachés à la même plage conductrice.

8. Transducteur selon l'une des revendications 1 à 6, dans lequel, pour les deux rangées (10,20), les doigts sont respectivement reliés à au moins deux plages conductrices (15,16;25,26) qui s'étendent de part et d'autre de la rangée, caractérisé en ce que ladite exception comprend le fait que des groupes consécutifs de doigts (31 à 36 ; 37 à 42) ont des figures symétriques de rattachement auxdites plages.

9. Transducteur selon la revendication 8, caractérisé en ce que chaque groupe (31 à 36) comprend un espace agrandi entre deux doigts, se trouvant ainsi composé de deux figures successives identiques de rattachement auxdites plages (31 à 33 ; 34 à 36).

## Patentansprüche

1. Akustoelektrische Oberflächenwellenvorrichtung, die auf einer Hauptfläche eines ebenen piezoelektrischen Substrats eine erste Reihe (10) von parallelen Leiterfingern sowie eine zweite Reihe (20) von parallelen Leiterfingern aufweist, wobei diese beiden Reihen voneinander beabstandet sind, um durch die Fortpflanzung von akustischen Oberflächenwellen (HF, NF) eine Kopplung zwischen den Fingern der ersten Reihe (11, 12) und denjenigen der zweiten (21, 22) zu ermöglichen, wobei die Finger zur Fortpflanzungsrichtung dieser akustischen Oberflächenwellen geneigt sind,
wobei die Finger der beiden Reihen entsprechend von einer Reihe zur anderen individuelle Geometrien aufweisen, die lokal in Abhängigkeit von einer Arbeitsfrequenz gewählt und global über einen weiten Arbeitsfrequenzbereich gestaffelt sind, um eine akustische Kopplung mit breitem Frequenzbereich zwischen den beiden Reihen von Fingern zu ermöglichen,
während die Anbringung der Finger entlang jeder Reihe einer vorbestimmten Sequenz in Kombination mit einem Maßstabsfaktor gehorcht, der mit der Arbeitsfrequenz verknüpft ist,
dadurch gekennzeichnet,
daß eine (20M) der beiden Reihen eine Ausnahme bezüglich der Sequenz aufweist, wobei diese Ausnahme entlang dieser Sequenz im wesentlichen periodisch wiederholt ist.

2. Wandler nach Anspruch 1,
dadurch gekennzeichnet,
daß die Finger der beiden Reihen (10, 20) untereinander parallel sind und daß sie individuelle Geometrien aufweisen, die fortschreitend entlang jeder Reihe variieren, um ein sehr breites Frequenzband abzudecken, wobei sie sich gleichzeitig von einer Reihe zur anderen senkrecht zur Richtung der Finger entsprechen.

3. Wandler nach Anspruch 2,
dadurch gekennzeichnet,
daß die Breite eines Fingers (11, 12, 21, 22) im wesentlichen ein vorbestimmtes Untervielfaches der halben Länge der zugeordneten akustischen Momentanwelle ist, während der Abstand zwischen angrenzenden Fingern im wesentlichen gleich diesem Untervielfachen oder ein Vielfaches davon ist.

4. Wandler nach einem der vorhergehenden Ansprüche,
dadurch gekennzeichnet,
daß die Ausnahme alle drei oder vier Finger eine Verbreiterung des Abstands zwischen den Fingern umfaßt.

5. Wandler nach einem der Ansprüche 2 bis 4,
dadurch gekennzeichnet,
daß die mittleren Richtungen der ersten und der zweiten Reihe (10, 20) unterschiedlich zur Senkrechten zur Richtung der Finger geneigt sind, wodurch dem Wandler Charakteristika einer Dispersionsstrecke verliehen werden.

6. Wandler nach einem der Ansprüche 2 bis 4,
dadurch gekennzeichnet,
daß die mittleren Richtungen der ersten und der zweiten Reihe (10, 20) im wesentlichen die gleiche Neigung zur Senkrechten zur Richtung der Finger aufweisen, wodurch dem Wandler Charakteristika einer nicht dispersiven Verzögerungsstrecke verliehen werden.

7. Wandler nach einem der Ansprüche 1 bis 6, bei dem wenigstens für eine (20M) der Reihen (10, 20) die Finger jeweils mit wenigstens zwei leitenden Bereichen (15, 16; 25, 26) verbunden sind, die sich beiderseits der Reihe erstrecken,
dadurch gekennzeichnet,
daß es die Reihe (20M) ist, welche mit den Bereichen versehen ist, die die Ausnahme aufweist, welchselbige die Tatsache umfaßt, daß im wesentlichen periodisch entlang der Sequenz zwei aufeinanderfolgende Finger (33, 34; 39, 40) an den gleichen leitenden Bereich angeschlossen sind.

8. Wandler nach einem der Ansprüche 1 bis 6, bei dem für die beiden Reihen (10, 20) die Finger jeweils mit wenigstens zwei leitenden Bereichen (15, 16; 25, 26) verbunden sind, die sich beiderseits der Reihe erstrecken,
dadurch gekennzeichnet,
daß die Ausnahme die Tatsache umfaßt, daß aufeinanderfolgende Gruppen von Fingern (31 bis 36; 37 bis 42) symmetrische Bilder des Anschlusses an die Bereiche aufweisen.

9. Wandler nach Anspruch 8,
dadurch gekennzeichnet,
daß jede Gruppe (31 bis 36) zwischen zwei Fingern einen vergrößerten Raum aufweist, wobei sie damit aus zwei hintereinanderfolgenden, identischen Bildern des Anschlusses an die Bereiche (31 bis 33; 34 bis 36) besteht.

## Claims

1. Acoustoelectric surface-wave device having, on a large face of a plane piezoelectric substrate, a first row (10) of parallel conductive fingers and a second row (20) of parallel conductive fingers, these two rows being spaced apart from each other, in order to allow coupling by the propagation of acoustic surface waves (HF, BF) between the fingers in the first row (11, 12) and those in the second (21, 22), the said fingers being inclined towards the direction of propagation of these acoustic surface waves,
the fingers in the two rows having, in correspondence from one row to the other, individual geometries chosen locally as a function of an operating frequency, and spaced out overall over a wide range of operating frequencies, to allow acoustic coupling across a wide frequency band between the two rows of fingers,
whilst the layout of the fingers along each row follows a predetermined sequence, combined with the scaling factor related to the operating frequency,
characterised in that one (20M) of the two rows has an exception with respect to the said sequence, this exception being repeated substantially periodically along this sequence.

2. Transducer according to Claim 1, characterised in that the fingers in the two rows (10, 20) are parallel with each other and in that they have individual geometries which vary progressively along each row in order to cover a very wide frequency band, whilst corresponding to each other from one row to the other perpendicularly to the direction of the fingers.

3. Transducer according to Claim 2, characterised in that the width of a finger (11, 12, 21, 22) is substantially a predetermined sub-multiple of the associated instantaneous acoustic half-wave length, whilst the distance between adjacent fingers is substantially equal to this sub-multiple, or a multiple thereof.

4. Transducer according to one of the preceding claims, characterised in that the said exception comprises a widening of the separation between fingers, every three or four fingers.

5. Transducer according to one of Claims 2 to 4, characterised in that the mean directions of the first and second rows (10, 20) incline differently towards the perpendicular to the direction of the fingers, which confers dispersive line characteristics on the transducer.

6. Transducer according to one of Claims 2 to 4, characterised in that the mean directions of the first and second rows (10, 20) have substantially the same inclination towards the perpendicular to the direction of the fingers, which confers non-dispersive delay line characteristics on the transducer.

7. Transducer according to one of Claims 1 to 6, in which, for at least one (20M) of the rows (10, 20), the fingers are respectively connected to at least two conductive strips (15, 16; 25, 26), which extend on each side of the row, characterised in that it is the said row (20M) provided with strips which includes the said exception, which comprises the fact that, substantially periodically along the sequence, two consecutive fingers (33, 34; 39, 40) are attached to the same conductive strip.

8. Transducer according to one of Claims 1 to 6, in which, for the two rows (10, 20), the fingers are respectively connected to at least two conductive strips (15, 16; 25, 26) which extend on each side of the row, characterised in that the said exception comprises the fact that consecutive groups of fingers (31 to 36; 37 to 42) have symmetrical patterns of attachment to the said strips.

9. Transducer according to Claim 8, characterised in that each group (31 to 36) comprises an enlarged space between two fingers, thus being composed of two identical successive patterns of attachment to the said strips (31 to 33; 34 to 36).
